Europäisches Patentamt

(19) European Patent Office

Office européen des brevets

(11) Publication number : **0 341 003 B1**

(12) **EUROPEAN PATENT SPECIFICATION**

(45) Date of publication of patent specification :
31.08.94 Bulletin 94/35

(51) Int. Cl.⁵ : **G02F 1/136**

(21) Application number : 89304361.2

(22) Date of filing : 28.04.89

(54) **Thin film semiconductor device and liquid crystal display apparatus using thereof.**

(30) Priority : 30.04.88 JP 108697/88
07.07.88 JP 169792/88

(43) Date of publication of application :
08.11.89 Bulletin 89/45

(45) Publication of the grant of the patent :
31.08.94 Bulletin 94/35

(84) Designated Contracting States :
**DE FR GB**

(56) References cited :
EP-A- 0 136 509
EP-A- 0 179 914
EP-A- 0 179 915
EP-A- 0 196 915
US-A- 4 599 246
US-A- 4 601 097

(73) Proprietor : **SHARP KABUSHIKI KAISHA**
**22-22 Nagaike-cho**
**Abeno-ku**
**Osaka 545 (JP)**

(72) Inventor : **Shoji, Hajime**
**1-2-43 Wakaehigashimachi**
**Higashiosaka-shi, Osaka (JP)**
Inventor : **Watanabe, Noriko**
**5-8,Sanjo-soekawa-cho**
**Nara-shi, Nara-ken (JP)**
Inventor : **Hamada, Hiroshi**
**177 Aoyama 7-chome**
**Nara-shi, Nara-ken (JP)**
Inventor : **Kato, Hiroaki**
**9-4, Tezukayama 1-chome**
**Nara-shi, Nara-ken (JP)**
Inventor : **Takemoto, Toshio**
**134-5, Fujiwaradai**
**Nara-shi, Nara-ken (JP)**
Inventor : **Hirobe, Toshihiko**
**2-20-604, Nakamachi, Ohama**
**Sakai-shi, Osaka (JP)**

(74) Representative : **Brown, Kenneth Richard et al**
**R.G.C. Jenkins & Co.**
**26 Caxton Street**
**London SW1H 0RJ (GB)**

## Description

The invention relates to a thin film semiconductor device. More particularly, the invention relates to a thin film semiconductor device which is suitable for use as a switching element for a picture element electrode in an active matrix type liquid crystal display apparatus. The invention relates further to a liquid crystal display apparatus which utilizes the thin film semiconductor device.

The active matrix drive system has been adopted to drive a liquid crystal display apparatus. See, for example, EP-A-0 179 915. This drive system drives a liquid crystal by providing a switching element and, as required, a signal storage element to each picture element electrode, which are integrated into a single device. In a liquid crystal display apparatus of the drive system mentioned above, a thin film transistor (TFT) is provided as a switching element in the vicinity of each picture element electrode, and a gate electrode and a source electrode which cross each other are provided to define an XY matrix. To the gate electrode, a control signal for switching the TFT is applied, and to the source electrode, a signal corresponding to information for display (hereafter referred to as a display signal) is applied, driving the thin film transistor and applying a display signal voltage across each picture element electrode connected to a drain electrode of the transistor and a counter electrode of the apparatus opposing thereto. In this way the display status of each liquid crystal display element is controlled.

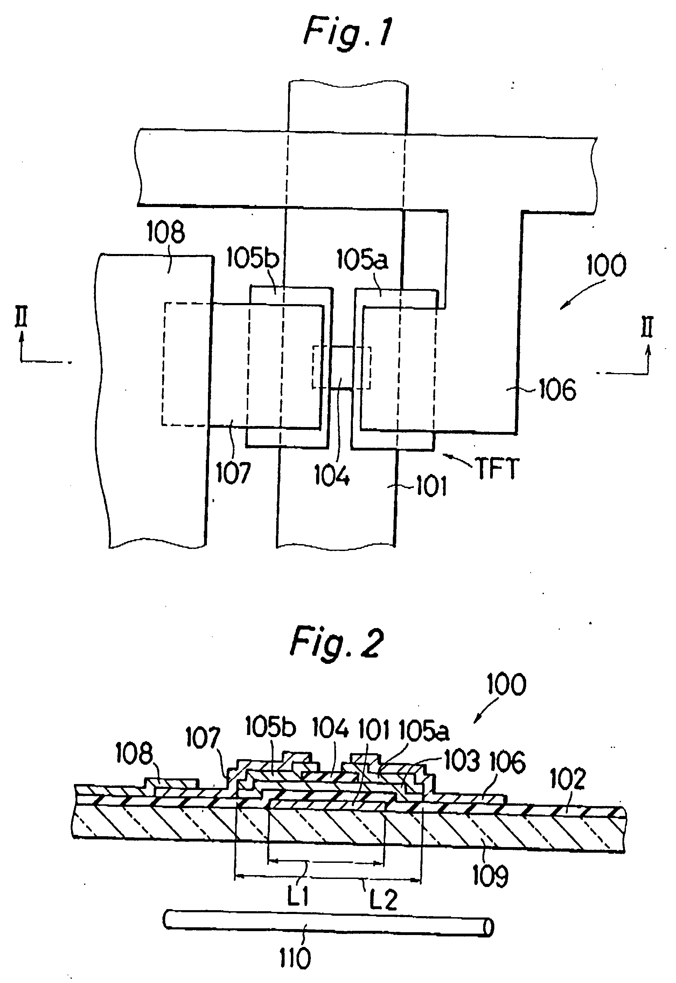

Fig. 1 is a plan view of the vicinity of a thin film semiconductor device of the prior art, and Fig. 2 is a cross-sectional view taken along a line II-II of Fig. 1. Referring to Fig. 2, the construction of a thin film semiconductor device 100 of the prior art will be explained. In the thin film semiconductor device 100, a thin film transistor comprises a gate electrode 101, a semiconductor layer 103 made of amorphous silicon film which is formed over a gate insulating film 102 formed over the gate electrode 101, a protective insulator film 104 formed over the semiconductor layer, n+ type semiconductor layers 105a and 105b made of phosphorus-doped n+ amorphous silicon film or the like which are formed over both the semiconductor layer 103 and the protective insulator film 104, and a source electrode 106 and a drain electrode 107 formed on the n+ type semiconductor layers 105a and 105b respectively. The thin film transistor is formed on an electrically insulating substrate 109 which is transparent, and further the drain electrode 107 is connected to a picture element electrode 108. A thin film transistor of this type is known from "An Amorphous-Si TFT Addressed 3.2 in Full-Color LCD", F. Funada et al, S.I.D. 1986 Digest, pages 293-295.

This conventional thin film transistor is formed so that the semiconductor layer extends beyond the edge of the gate electrode as shown in Fig.1. This is to reduce the risk of the leakage which might break out between the gate and the source at the side wall of the gate edge resulting from damage to the gate insulating film during patterning of the n+ type semiconductor layer. According to the construction of the conventional thin film transistor, it is obvious in actuality that such problem as the leakage between the gate and source due to damage of the gate insulating film does not occur.

In a liquid crystal display apparatus of the conventional active matrix drive system, the signals are applied to the gate electrode and the source electrode, driving the thin film transistor located at each intersection and controlling a current flowing between the source electrode and the drain electrode, and thereby optical characteristics such as rotatory power and transmissivity of the liquid crystal display element are controlled. The presence of a defect in the ON/OFF switching characteristics in the multitude of thin film transistors provided in the display region will cause such deterioration of the display quality as degradation of the contrast and the uniformity. One of the causes of this defect is the increase in the off current. The off current refers to the leakage current flowing when the thin film transistor is kept off by setting gate level low. The leakage current is caused by the carriers generated in the semiconductor layer constituting the thin film transistor by thermal excitation and optical excitation, for example.

In an experiment with a transmission type liquid crystal display apparatus formed with the thin film semiconductor 100 shown in Fig.1, it has been confirmed that the light, emitted by a light source 110 provided at another side of the substrate 109 than that where the thin film transistors are formed, is irradiated onto the semiconductor layer 103 which is formed by extending beyond the gate electrode 101 to the left and right shown in Fig.2, generating the carriers by optical excitation, thereby resulting in the increase of off current. Namely, the problem arises from the fact that light irradiates the semiconductor layer 103 because the width L2 of the semiconductor layer 103 is larger than the width L1 of the gate electrode 101.

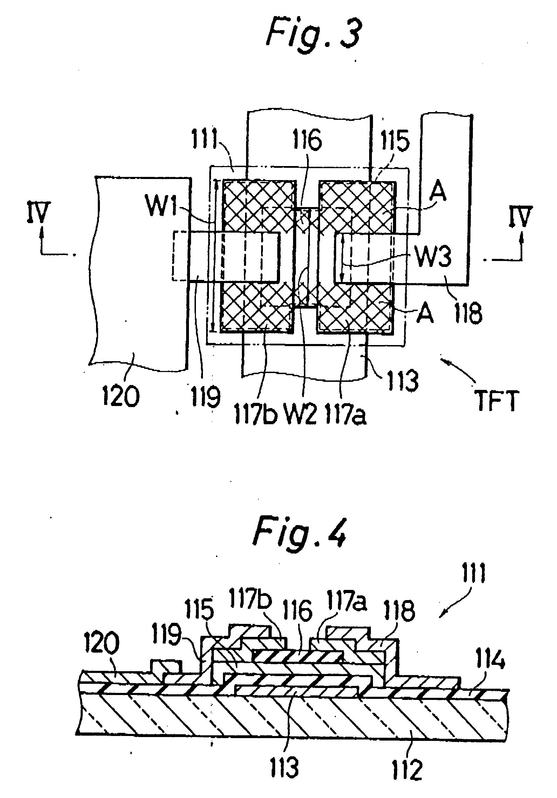

Fig.3 is a plan view of a thin film semiconductor device 111 which is another prior art and Fig.4 is a cross-sectional view taken along a line IV-IV of Fig.3. Referring to Fig.3 and Fig.4, this other conventional semiconductor device 111 will be explained. Over an electrically insulating substrate 112 is formed a gate electrode 113 made of chromium, tantalum or the like, and further a gate insulating film 114 made of silicon nitride, tantalum pentoxide, silicon dioxide or the like is formed for the purpose of insulation between the gate electrode 113 and other electrodes.

On the gate insulating film 114 which covers the gate electrode 113, a semiconductor layer 115 made of amorphous silicon which can be a channel region of the thin film transistor 111 is formed. Over the semiconductor layer 115 is stacked a protective insulator layer 116 made of silicon nitride or the like and is formed so that the central part remains through photo-etching or the like. On the part of the semiconductor layer 115 where the protective insulator film 116 has been removed, n+ type semiconductor layers 117a and 117b where electrons are majority carrier by doping of phosphorus are formed, for the purpose of forming a source electrode and a drain electrode. n+ type semiconductor layers 117a and 117b cover each edge of the protective insulator film 116 too, and are arranged to oppose without making contact with each other on the protective insulator film 116. Each side of the semiconductor layer 115 is completely covered with both the protective insulator film 116 and the n+ type semiconductor layers 117a and 117b. Thus, thin film transistors are formed over the substrate 112.

On one of the n+ type semiconductor layers 117a and 117b is formed a source electrode 118 and on the other is formed a drain electrode 119. These electrodes are made of chromium, titanium, molybdenum, aluminium or the like. An opposite end to the n+ type semiconductor 117b of the drain electrode 119 is electrically connected to the picture element electrode 120 of the liquid crystal display element. Moreover it is fine too, that both the drain electrode 119 and the picture element electrode 120 are integrated with the transparent electrode made of indium tin oxide or the like.

In the following explanation, a direction L and a direction W will be defined as follows. A direction L is (1): an opposed direction of the source electrode and the drain electrode, (2): a direction of a channel of current between the source electrode and the drain electrode, (3): a direction crossing the gate electrode. The direction L of both the prior art and an embodiment of the invention to be described below satisfies the definition (1), (2), (3). Moreover a direction W is a direction perpendicular to said direction L.

In the prior art shown in Fig.3, in the protective insulator film 116, the n+ type semiconductor layers 117a and 117b and the source and drain electrodes 118 and 119, in the direction W perpendicular to the direction in which the n+ type semiconductor layers 117a and 117b oppose each other, namely in the lengthwise direction in Fig.3, the widths W1, W2 and W3 are selected to satisfy the following relation:

$$W1 \geqq W2 > W3 \quad (1)$$

where W1 is the width of the contact region between the semiconductor layer and the n+ type semiconductor layer, W2 is the width of the channel region, and W3 is the width of the source electrode and the drain electrode, respectively.

In the usual operation of the liquid crystal display, light for illumination is irradiated from the opposite side of the substrate 112.

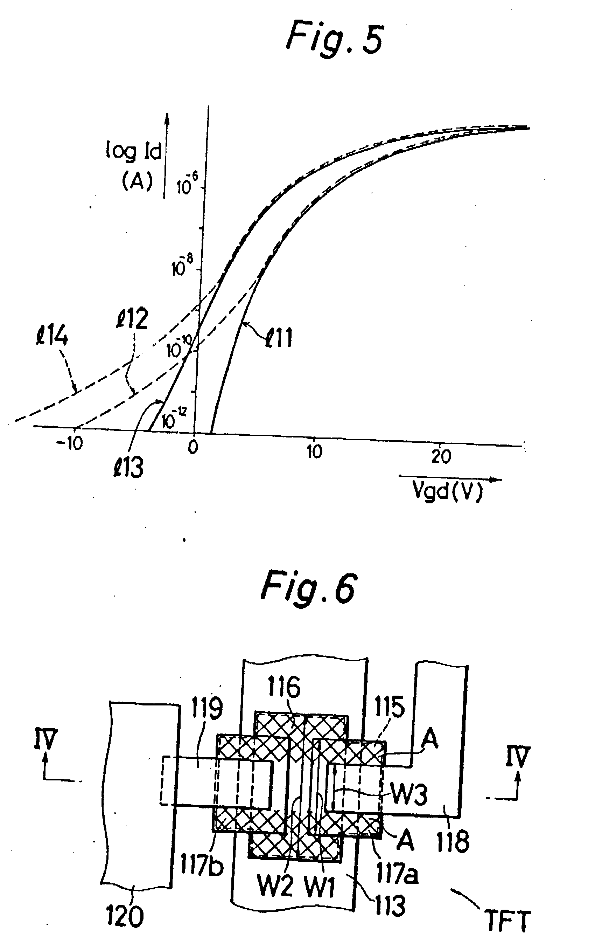

Fig.5 shows a graph of gate-drain voltage Vgd vs drain current Id characteristic. In initial condition, namely under a dark condition before the operation for a prolonged duration under the radiation of light, gate-drain voltage Vgd vs drain current Id characteristic is as indicated by the solid line $\ell 11$ of Fig.5. Further the gate-drain voltage Vgd vs drain current Id characteristic measured under a condition that the carriers have been generated in the semiconductor layer 115 by the irradiation of light, indicates that the characteristic when the TFT is off varies from the solid line $\ell 11$ of Fig.5 to as the dashed line $\ell 12$. The degree of the variation of the off characteristic is dependent on the luminous intensity. If the operating time under the radiation of light were comparatively short enough, the variation between the characteristic $\ell 11$ and the characteristic $\ell 12$ would be reversible. Therefore after interrupting the radiation of light, the Vgd-Id characteristic measured under a dark condition will revert again to the characteristic shown as $\ell 11$.

On the other hand, after the operation for a prolonged duration under the radiation of light, the Vgd-Id characteristic shifts in a negative direction of Vgd such as to the solid line $\ell 13$ under a dark condition and to the dashed line $\ell 14$ under the radiation of light. The scale of shift is dependent on the luminous intensity and the operating duration under the radiation of light. Therefore, as the luminous intensity is increased and the operating duration under the radiation of light is prolonged, the shift is larger. The mechanism of this phenomenon will be explained in the following.

In case the light is irradiated from the other side of the substrate 112, because the gate insulating film 114 is transparent, the light reaches to the region in the semiconductor layer 115 where it is not cut off by the gate electrode 113. The energy of this light will generate the carriers consisting of electron-hole pairs in the semiconductor layer 115. In this condition, namely after the operation for a prolonged duration under the radiation of light, in the region A, where the electric field intensity in the direction between the source and the drain electrodes is weak, indicated by the cross hatched area in Fig.3, drift time for carriers (running time in channel) will be longer than that in the channel region where said intensity is strong. Therefore, the probability of the trapping of the carriers into the gate insulating film 114 by the gate-drain voltage Vgd applied to the gate electrode 114 will be high. Then, the threshold voltage Vth will be shifted by the trapped carriers.

Consequently, in the configuration of the thin film semiconductor device 111, in the case of operation for a prolonged duration under the irradiation of light, the switching element will not be completely turned off even when the gate-drain voltage Vgd is so controlled that the switching element is turned off to reserve the carriers accumulated between the display element electrode 120 and the counter electrode. Therefore, the effective voltage to apply to the liquid crystal layer will be decayed. Consequently, unevenness may be caused in the display quality or the contrast may become weaker. In other words, as the functional quality of the thin film semiconductor 111 degrades, the reliability of the liquid crystal display element which incorporates the thin film semiconductor 111 is poor.

Fig.6 is a plan view of a third prior art of thin film transistor, where the reference symbols the same as those in Fig.3 represent parts identical or corresponding to those in Fig.3. A cross-sectional view taken along a line IV-IV in Fig.6 is the same as Fig.4. The differences from the thin film semiconductor device 111 of Fig.3 are the shape of the semiconductor layer 115 and the size of both the protective insulator film 116 and the n+ type semiconductor layers 117a and 117b. In the protective insulator film 116, the n+ type semiconductor layers 117a, 117b and the source and the drain electrodes 118, 119 in Fig.6, widths W1, W2 and W3 in the same direction as that shown in Fig.3 are selected to satisfy the relation:

$$W2 \gtrsim W1 > W3 \quad (2)$$

As before W1 is the width of the contact region between the semiconductor layer and the n+ type semiconductor layer, W2 is the width of the channel region, and W3 is the width of each of the source electrode and the drain electrode.

Also, in a thin film semiconductor device of a configuration such as shown in Fig.6, there exists an area A indicated by the cross hatched area where the electric field intensity in the direction between the source and the drain electrodes is weak. Therefore, in case the device is operated for a prolonged duration under the irradiation of light, the probability that carriers are generated in the semiconductor layer 115 and are trapped in the gate insulating film in the area A where the electric field intensity in the direction between the source and the drain electrodes is weak, will be high. These trapped carriers cause a shift in the gate-drain voltage Vgd vs drain current Id characteristic similar to the case of the thin film semiconductor device 111 of Fig.4, resulting in degradation of the functional quality of the thin film semiconductor device. This also means the reliability of the device is poor.

The models used for the explanation of the undesirable phenomena in the prior art as described above were investigated. As a result, the influence of the light in various shaped TFT was examined. Therefore on the basis of the consideration, the present invention proposes a satisfactory solution of the problem in the prior art.

The first object of the invention is to provide a thin film semiconductor device which is capable of decreasing the off current caused by the generation of carriers through optical excitation and decreasing the shift of threshold voltage Vth, and a liquid crystal display apparatus which uses the thin film semiconductor device.

The second object of the invention is to provide a thin film semiconductor device which does not accumulate carriers generated by the optical excitation in the semiconductor layer and is thereby capable of preventing the deterioration of the quality of a liquid crystal display apparatus using the thin film semiconductor device, and improving the reliability thereof.

In a first aspect, the invention provides a thin film semiconductor device comprising a laminated structure disposed on an electrically insulating substrate, said laminated structure comprising:

a gate electrode formed on said substrate;

a first insulating layer covering said gate electrode and said substrate;

a semiconductor layer formed on said first insulating layer over said gate electrode;

a second insulating layer formed on said semiconductor layer such that only the part around the centre on the semiconductor layer remains, said second insulating layer having a first width first width in a first direction substantially perpendicular to the direction of current flow through said semiconductor layer when the device is turned on;

source/drain semiconductor regions formed substantially on said semiconductor layer and arranged to have a second width in a direction substantially parallel to said first direction; and

source/drain electrodes formed substantially on said respective source/drain semiconductor regions and arranged to have a third width in a direction substantially parallel to said first direction,

characterised in that:

said third width is greater than or equal to said second width and said second width is greater than or equal to said first width.

In a second aspect, the invention provides a liquid crystal display apparatus comprising thin film semiconductor devices according to said first aspect, and having row electrodes and column electrodes intersecting with and mutually insulated from each other and formed on said electrically insulating substrate, a said thin film semiconductor device being provided at each intersection of said row electrodes and said column electrodes.

According to the invention, by virtue of the relationship between the lengths in the direction W of the source/drain electrodes, the source/drain regions and the channel region there is no area in the semiconductor layer where the electric field intensity in the direction between the source and drain electrodes is weaker than that in the channel region. Therefore, even after an operation under irradiation of light for a prolonged duration, a travelling time for carriers generated by the irradiation of light to pass through the semiconductor layer is short. Consequently, because the probability that carriers are trapped in the insulator layer is also quite low, the shift in the characteristic of the thin film semiconductor device caused by the carriers is negligibly small. Therefore, deterioration of the functional quality of the semiconductor device can be prevented and the reliability of the thin film semiconductor device is improved.

According to a preferred embodiment of the invention, no part of the semiconductor layer extends beyond the gate electrode. Thus, when light is irradiated from the side of the electrically insulating substrate opposite to that on which the device is laminated, the light is cut off at the gate electrode and therefore is not irradiated onto the semiconductor layer. Consequently, carriers are not generated by optical excitation and the off current caused by the carriers can be substantially reduced. Further, shift of threshold voltage Vth when the device is operated for a prolonged duration under the radiation of light decreases to a level which is negligible in usual operation.

According to the invention, because a thin film semiconductor device of high quality can be provided, display quality of the liquid crystal display apparatus is greatly improved.

Fig.1 is a plan view of a conventional thin film semiconductor device 100.

Fig.2 is a cross-sectional view taken along a line II-II of Fig.1.

Fig.3 is a plan view of a second thin film semiconductor device 111 which is prior art.

Fig.4 is a cross-sectional view taken along a line IV-IV of Fig.3.

Fig.5 is a graph which is explanatory of the gate-drain voltage Vgd vs drain current Id characteristic.

Fig.6 is a plan view of a third thin film semiconductor device which is prior art.

Fig.7 is a plan-view of a thin film semiconductor device which is an embodiment of the invention.

Fig.8 is a cross-sectional view taken along a line VIII-VIII of Fig.7

Fig.9 is an oblique view of a cross section of a liquid crystal display section equipped with a thin film semiconductor device of the invention.

Fig.10 is a cross-sectional view indicative of the simplified structure of an active matrix type liquid crystal display apparatus.

Fig.11 is a drawing for the explanation of the operating principle of an active matrix type liquid crystal display apparatus.

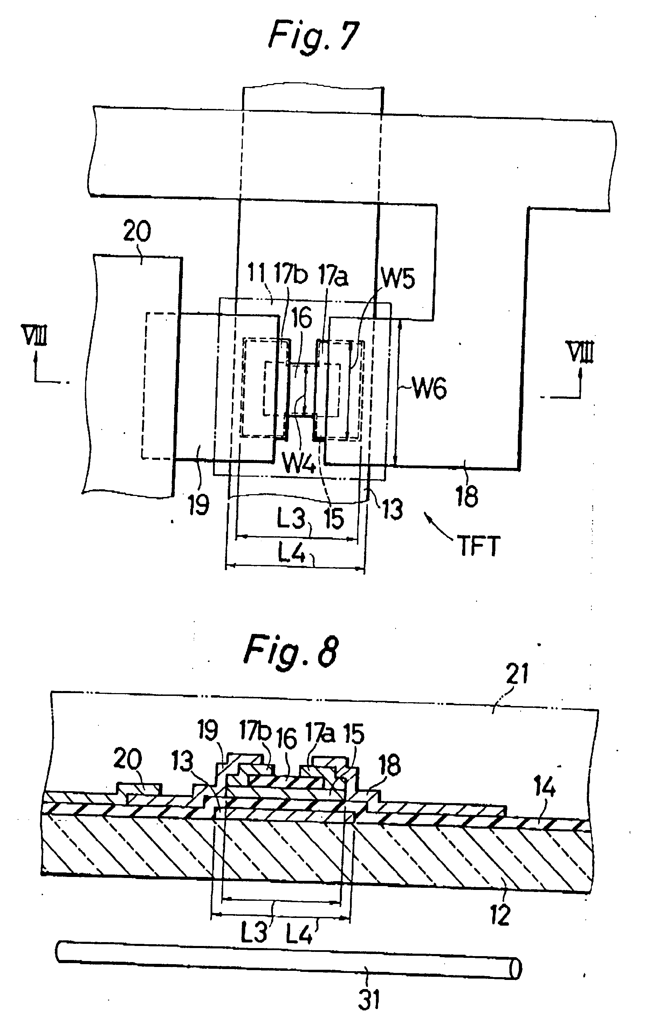

Referring to Fig.7 and Fig.8, the thin film semiconductor device 11 which is an embodiment of the invention will be explained in the following.

Each film of which the thin film semiconductor device described hereinafter is composed is usually patterned into a desired shape by conventional photolithographic technique. First, a gate electrode 13 is formed by stacking metal such as chromium or tantalum by means of spattering on an electrically insulating substrate 12 such as a transparent glass substrate. A gate insulating film 14 made of silicon nitride, tantalum pentoxide, silicon dioxide or the like is formed over the entire area of one surface of the substrate 12 where the gate electrode 13 is formed. The gate insulating film 14 is provided for the purpose of electrically insulating the gate electrode 13 formed on the substrate 12 from a semiconductor layer to be described later and other bus line for electrodes.

On the gate insulating film 14, a semiconductor layer 15 made of amorphous silicon or the like which makes a channel of a thin film transistor and a protective insulator film 16 made of silicon nitride or the like are consecutively stacked by the plasma CVD method. The protective insulator film 16 stacked at the top layer is formed into such a shape that only the part around the centre on the semiconductor layer 15 remains by means of photo-etching or the like.

In order to form a source electrode and a drain electrode on the surface of the semiconductor layer 15 of which both sides are exposed so that the protective insulator film 16 is the boundary, n+ type semiconductor layers 17a and 17b of n+ amorphous silicon film or the like, made by doping phosphorus in amorphous silicon, are stacked by plasma CVD method so that they oppose each other without making contact and are patterned together with the semiconductor layer 15. Therefore, a surface of the semiconductor layer 15 which does not face the gate insulating film 14 is completely covered with either the protective insulator film 16 or the n+ type semiconductor layers 17a and 17b. The stacked n+ type semiconductor layers 17a and 17b are formed together with the semiconductor layer 15 so that their peripheries are confined within the area on the gate electrode 13. A metal such as chromium, aluminium, titanium, molybdenum or the like is stacked on the n+ type semiconductor layers 17a and 17b by spattering method to form a source electrode 18 and a drain electrode 19. Then a transparent conductive film made of indium tin oxide (ITO), for example, is stacked to form picture element electrodes 20 by means of spattering.

When etching both the n+ semiconductor layers 17a and 17b and the semiconductor layer 15 simultaneously, these are formed in patterns with widths in the direction L smaller than the width of the gate electrode. Namely the n+ semiconductor layers 17a and 17b and the semiconductor layer 15 are formed so that the widths L3 and L4 shown in the left to right direction in Fig.7 satisfy the following inequality:

$$L3 < L4 \quad (3)$$

Therefore, a thin film semiconductor device which has no part of the semiconductor layer 15 extending beyond the gate electrode 13 in the direction L (left to right direction in Fig.8) is formed.

According to the construction of the thin film semiconductor device, the semiconductor layer 15 is shielded with the gate electrode 13 when viewing the thin film transistor from the side of substrate 12 where the thin film transistor is not formed. Therefore, light irradiated from below in Fig.8 is cut off at the gate electrode 13 without reaching the semiconductor layer 15. Thus, the generation of carriers in the semiconductor layer 15 by the optical excitation can be surely prevented. Therefore, off current due to the carriers generated by the optical excitation can surely be reduced.

Also, in the construction of the thin film semiconductor device, widths W4, W5 and W6 in the direction W (vertical direction in Fig.7) perpendicular to the direction in which the n+ semiconductor layers 17a and 17b oppose each other, namely the width of the protective insulator film 16, the width of n+ semiconductor layers 17a and 17b, and the width of the source and drain electrodes 18 and 19 are selected to satisfy the following inequality:

$$W6 \geqq W5 \geqq W4 \quad (4)$$

In other words, W4 is the width of the channel region, W5 is the width of the contact region between the semiconductor layer and the n+ type semiconductor layer, and W6 is the width of each of the source electrode and the drain electrode.

According to the above-mentioned construction, because the width W6 of the source and drain electrodes 18 and 19 is equal to or larger than the width W5 of the longest part of the semiconductor 15 in the direction W perpendicular to the direction where the n+ type semiconductor layers 17a and 17b are opposed to each other, no such area A as in the prior art, where the electric field intensity in the direction between the source and the drain electrodes is weak, exists in the semiconductor layer 15. Therefore, in the case of operation for a prolonged duration under the irradiation of light, even when carriers are generated in the semiconductor layer 15 due to the light irradiated and carried after irradiation, because the carriers are not accumulated, the probability of trapping for carriers into the gate insulating film is quite low. In other words, shift in the gate-drain voltage Vgd vs drain current Id is negligibly small.

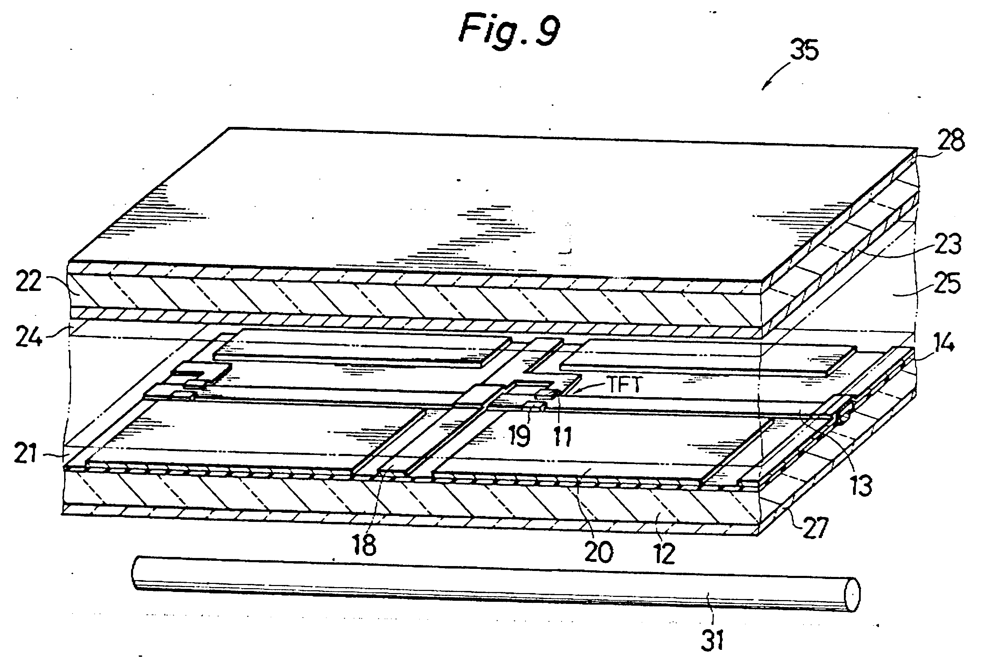

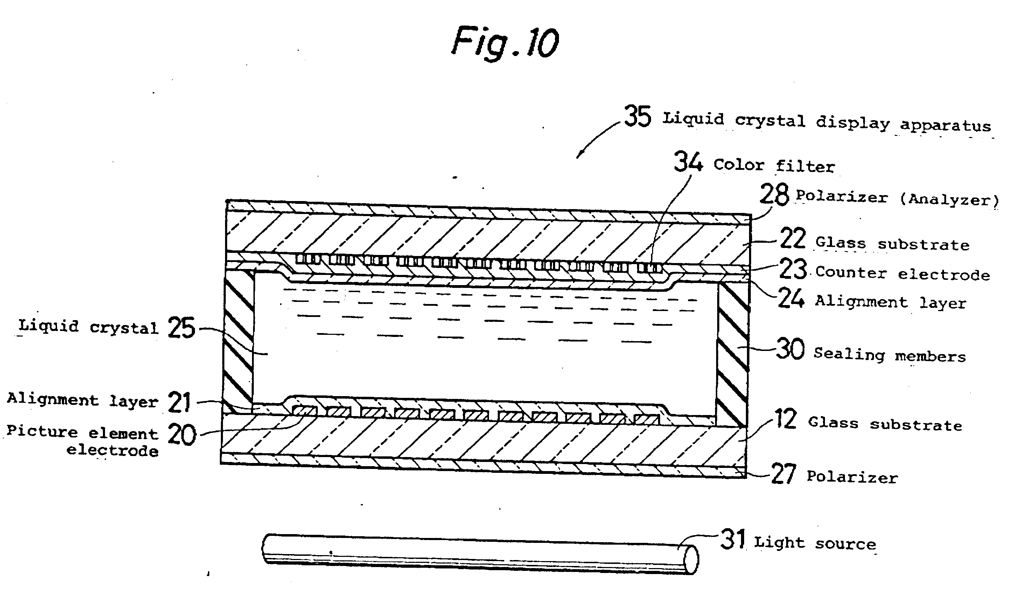

The thin film semiconductor device made in the construction previously described operates, for example, as a switching element of each picture element electrode in a liquid crystal display apparatus of active matrix drive system. Referring to Fig.9 and Fig.10 a liquid crystal display apparatus provided with the thin film semiconductor device is explained in the following.

On one surface of one glass substrate 12 opposed to another glass substrate 22 there is formed a gate electrode 13 which extends in left to right direction in Fig.9 at constant intervals. A gate insulator film 14 is formed over the entire area of one surface of the substrate 12 where the gate electrode 13 is formed. On the gate insulator film 14 there is formed a source electrode 18 at constant intervals in the direction perpendicular to the gate electrode 13. Thin film transistors based on the construction of the thin film semiconductor device of the invention are formed on the gate insulator film 14 which covers the gate electrode 13, corresponding to the vicinities of each intersection of the gate electrodes 13 and the source electrodes 18. The drain electrode 19 is connected to the picture element electrodes 20 in the thin film transistors. An alignment layer 21 is formed on the structure described above which is formed on the substrate 12, for the purpose of alignment of the molecular axis of the liquid crystal. On the other surface of the substrate 12 there is arranged a polarizer 27.

On one surface of the other glass substrate 22 opposed to the glass substrate 12 there is formed counter electrode 23, which extends in the left to right direction in Fig.9, and an alignment layer 24 is formed on the surface where the counter electrode 23 is formed. Also, as shown in Fig. 10, a colour filter 34 is arranged at the position of the substrate 12 which opposes the picture element electrode for the purpose of colour display. Further, on the other surface of the glass substrate 22 there is arranged a polarizer 28, which is also called analyzer.

A liquid crystal display apparatus 35 is constituted by opposing the glass substrates 12 and 22, and filling the space between the alignment layers 21, 24 and sealing members 30 which support the glass substrates with liquid crystal 25. The liquid crystal display apparatus 35 is indicated as a transmission type liquid display apparatus in this embodiment, and a light source 31 is provided outside of one polarizer 27 (bottom side in Fig. 9 and Fig. 10).

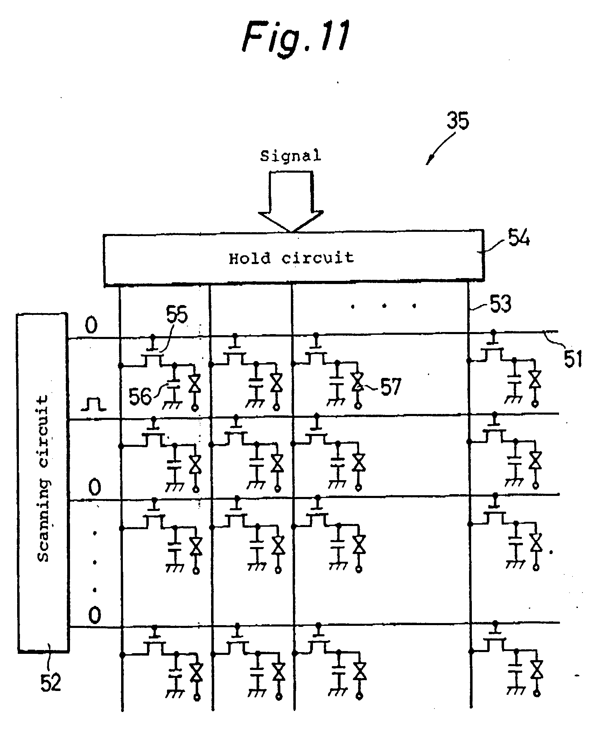

Fig.11 shows the operating principle of the liquid crystal display apparatus of active matrix drive system, when provided with signal storage elements, using thin film transistors as the switching elements. In this figure, the liquid crystal display apparatus 35 comprises a scanning circuit 52 which is connected to a gate bus 51, hold circuit 54 which supplies display signals to a source bus 53, thin film transistors 55 each of which operates as a switching element and which is provided at an intersection of a matrix constituted by a gate bus and a source bus, a signal storage capacitor 56 to hold the display signals, and a liquid crystal display element 57. The liquid crystal display apparatus scans the scanning electrodes of the gate bus 51 in order by line sequential procedure, turns on all thin film transistors 55 on one gate bus 51 simultaneously, and supplies display signals to each of the signal storage capacitors 56 from the hold circuit 54 via the source bus 53. The supplied display signal is capable of exciting the liquid crystal until the next frame is actuated.

Display operation of the liquid crystal display apparatus of the active matrix drive system constituted as described above will be briefly explained in the following, taking the twisted nematic mode and the normally white mode as examples.

Under a condition where no voltage is applied to the liquid crystal 25, crystal molecules of the liquid crystal 25 are oriented in the twisted nematic state by the alignment layers 21 and 24. The polarizing directions of polarizers 27 and 28 are so arranged that light irradiated by a light source 31 is polarized in the predetermined direction and transmits through the liquid crystal and exits to the outside. However, when predetermined voltage is applied to the gate electrode 13 of the thin film transistor via the gate bus lines 51, carriers are accumulated in the semiconductor layer 15 above the gate electrode 13, and the source electrode 18 and the drain electrode 19 are made to conduct. Since the source electrode 18 is always provided with the voltage of the display signal via the source bus lines 53, voltage is applied to the picture element electrode 20 by turning on the thin film transistor. Therefore, electric field is generated between the picture element electrode 20 and the counter electrode 23 which oppose each other with the liquid crystal 25 interposed therebetween.

Consequently, orientation of the liquid crystal molecules of the liquid crystal 25 is changed by the electric field and the polarization direction of the incident light from the light source 31 is made different from the polarization direction of the polarizer 28, and is made not to transmit light to the outside. When this display operation is viewed from the display side, namely from the top in Fig.10, the picture element is put into a dark condition when the display signal voltage stored in the storage capacitor 56 and applied to the liquid crystal is greater than a threshold voltage of liquid crystal, and otherwise the picture element is put into transparent condition to provide colour display corresponding to the coloration of the colour filter 34. With this principle, by individually operating a very large number of picture elements arranged in matrix over the entire display surface, a desired image or information can be displayed.

Therefore, according to the thin film semiconductor device of the above-mentioned construction, off current can be substantially reduced. The liquid crystal display apparatus which uses the thin film semiconductor device as a switching element is capable of greatly improving the quality because such deterioration of display quality as the degradation of contrast and uniformity can be avoided.

Although the description of the above embodiment deals with the transmission type liquid crystal display apparatus, the present invention is also applicable to a reflection type liquid display apparatus.

In a reflection type liquid crystal display apparatus, the intensity of light irradiated to the thin film transistor is generally made low. That is, by coating the side of substrate where the thin film transistor is not formed with an opaque material of matrix state called the black matrix at the position opposing the thin film transistor, light irradiated to the thin film transistor is substantially cut off thereby to prevent the light from reaching the semiconductor layer. Thus generation of carriers due to optical excitation does not occur.

Although the description of the embodiment of the invention deals with the thin film semiconductor device used in a liquid crystal display apparatus, the thin film semiconductor device may be used in an apparatus other than a liquid crystal display apparatus.

Although in the embodiment the n+ type semiconductor layers 17a and 17b are made by doping phosphorus in an amorphous silicon film, n+ type semiconductor layers 17a and 17b may be made by doping arsenic in an amorphous silicon film. Also, a p+ type semiconductor layer formed by doping boron in an amorphous silicon film may be used as the constitution of the thin film transistor.

Further, in the above-mentioned embodiment, width W5 of the n+ type semiconductor layers 17a and 17b in the direction W perpendicular to the direction L where the n+ semiconductor layers 17a and 17b are opposed to each other, namely the width of the contact region between the semiconductor layer and n+ type semiconductor layer is selected to be equal to or larger than the width W4 of the protective insulator film 16, namely the width of the channel region in the semiconductor layer in the direction W. Even when the semiconductor layer 15 is formed into a cross shape such as the semiconductor layer 115 of Fig.6 and the width W4 of the protective insulator film 16 (the width of the channel region) in the direction W is made larger than the width W5 of the n+ type semiconductor layers 17a and 17b (the width of the contact region) in the direction W, the same result as in the above-mentioned embodiment can be obtained by making the width W6 of the source and drain electrodes 18 and 19 in the direction W larger than both width W4 and width W5.

The invention may also be embodied in a variety of ways other than those preferred embodiments cited above without departing from the scope of the invention. Therefore, those preferred embodiments cited above are merely illustrative examples. The scope of the invention is explicitly manifested in the following claims.

## Claims

1. A thin film semiconductor device (11) comprising a laminated structure (13 to 19) disposed on an electrically insulating substrate (12), said laminated structure (13 to 19) comprising:

   a gate electrode (13) formed on said substrate (12);

   a first insulating layer (14) covering said gate electrode (13) and said substrate (12);

   a semiconductor layer (15) formed on said first insulating layer (14) over said gate electrode;

a second insulating layer (16) formed on said semiconductor layer (15) such that only the part around the centre on the semiconductor layer (15) remains, said second insulating layer (16) having a first width (W4) in a first direction substantially perpendicular to the direction (L) of current flow through said semiconductor layer (15) when the device (11) is turned on;

source/drain semiconductor regions (17a, 17b) formed substantially on said semiconductor layer (15) and arranged to have a second width (W5) in a direction substantially parallel to said first direction; and

source/drain electrodes (18, 19) formed substantially on said respective source/drain semiconductor regions (17a, 17b) and arranged to have a third width (W6) in a direction substantially parallel to said first direction,

characterised in that:

said third width (W6) is greater than or equal to said second width (W5) and said second width (W5) is greater than or equal to said first width (W4).

2. A thin film semiconductor device (11) according to claim 1, wherein no part of said semiconductor layer (15) extends beyond said gate electrode (13).

3. A liquid crystal display apparatus (35) comprising thin film semiconductor devices (55) according to claim 1 or claim 2, and having row electrodes (51) and column electrodes (53) intersecting with and mutually insulated from each other and formed on said electrically insulating substrate (12), said thin film semiconductor device (55) being provided at each intersection of said row electrodes (51) and said column electrodes (53).

**Patentansprüche**

1. Dünnfilm-Halbleitervorrichtung (11), mit einer Laminatstruktur (13 bis 19), die auf einem elektrisch isolierenden Substrat (12) angeordnet ist, wobei die Laminatstruktur (13 bis 19) folgendes aufweist:

- eine auf dem Substrat (12) ausgebildete Gateelektrode (13);
- eine die Gateelektrode (13) und das Substrat (12) abdekkende erste Isolierschicht (14);
- eine auf der ersten Isolierschicht (14) über der Gateelektrode ausgebildete Halbleiterschicht (15);
- eine auf der Halbleiterschicht (15) so ausgebildete zweite Isolierschicht (16), daß nur der Teil um die Mitte der Halbleiterschicht (15) verbleibt, wobei die zweite Isolierschicht (16) eine erste Breite (W4) in einer ersten Richtung im wesentlichen rechtwinklig zur Richtung (L) des Stromflusses durch die Halbleiterschicht (15), wenn die Vorrichtung (11) eingeschaltet wird, aufweist;

- Source/Drain-Halbleiterbereiche (17a, 17b), die im wesentlichen auf der Halbleiterschicht (15) ausgebildet sind und so angeordnet sind, daß sie eine zweite Breite (W5) in einer Richtung im wesentichen parallel zur ersten Richtung aufweisen; und
- Source/Drain-Elektroden (18, 19), die im wesentlichen auf den jeweiligen Source-/Drain-Halbleiterbereichen (17a, 17b) ausgebildet sind und so angeordnet sind, daß sie eine dritte Breite (W6) in einer Richtung im wesentlichen parallel zur ersten Richtung aufweisen;

**dadurch gekennzeichnet**, daß:

- die dritte Breite (W6) größer ist als die zweite Breite (W5) oder gleich groß und daß die zweite Breite (W5) größer ist als die erste Breite (W4) oder gleich groß.

2. Dünnfilm-Halbleitervorrichtung (11) nach Anspruch 1, bei der sich kein Teil der Halbleiterschicht (15) über die Gateelektrode (13) hinaus erstreckt.

3. Flüssigkristallanzeige (35) mit Dünnfilm-Halbleitervorrichtungen (55) nach Anspruch 1 oder Anspruch 2, und mit Zeilenelektroden (51) und Spaltenelektroden (53), die einander schneiden, gegeneinander isoliert sind und auf dem elektrisch isolierenden Substrat (12) ausgebildet sind, wobei die Dünnfilm-Halbleitervorrichtung (55) an jeder Schnittstelle zwischen den Zeilenelektroden (51) und den Spaltenelektroden (53) ausgebildet ist.

**Revendications**

1. Composant à semiconducteur en couches minces (11) comprenant une structure multicouche (13 à 19) disposée sur un substrat électriquement isolant (12), ladite structure multicouche (13 à 19) comprenant :

une électrode de grille (13) formée sur ledit substrat (12) ;

une première couche isolante (14) recouvrant ladite électrode de grille (13) et ledit substrat (12) ;

une couche semiconductrice (15) formée sur ladite première couche isolante (14), au-dessus de ladite électrode de grille ;

une deuxième couche isolante (16) formée sur ladite couche semiconductrice (15) d'une façon telle que seule subsiste la partie située autour du centre, sur la couche semiconductrice (15), ladite deuxième couche isolante (16) présentant une première largeur (W4) dans une première direction sensiblement perpendiculaire à la direction (L) de passage du courant à travers ladite couche semiconductrice (15), quand le composant (11) est placé dans l'état passant ;

des régions semiconductrices source-/drain (17a,17b) formées sur l'essentiel de ladite couche semiconductrice (15) et aménagées pour présenter une deuxième largeur (W5) dans une direction sensiblement parallèle à ladite première direction ; et

des électrodes source/drain (18,19) respectivement formées sur l'essentiel desdites régions semiconductrices source/drain (17a,17b) et aménagées pour présenter une troisième largeur (W6) dans une direction sensiblement parallèle à ladite première direction,

caractérisé en ce que :

ladite troisième largeur (W6) est supérieure ou égale à ladite deuxième largeur (W5) et ladite deuxième largeur (W5) est supérieure ou égale à ladite première largeur (W4).

2. Composant à semiconducteur en couches minces (11) selon la revendication 1, dans lequel aucune partie de ladite couche semiconductrice (15) ne s'étend au-delà de ladite électrode de grille (13).

3. Dispositif d'affichage à cristaux liquides (35) comprenant des composants à semiconducteur en couches minces (55), conformes à la revendication 1 ou à la revendication 2, et comportant des électrodes de lignes (51) et des électrodes de colonnes (53), qui se croisent et sont mutuellement isolées les unes des autres et qui sont formées sur ledit substrat électriquement isolant (12), un composant à semiconducteur en couches minces (55) étant disposé à chaque intersection desdites électrodes de lignes (51) et desdites électrodes de colonnes (53).

## Fig.1

## Fig.2

## Fig. 3

## Fig. 4

# Fig. 5

# Fig. 6

# Fig. 7

# Fig. 8

Fig.9

EP 0 341 003 B1

# Fig.10

35 Liquid crystal display apparatus

34 Color filter

28 Polarizer (Analyzer)

22 Glass substrate

23 Counter electrode

24 Alignment layer

Liquid crystal 25

30 Sealing members

Alignment layer 21

Picture element 20
electrode

12 Glass substrate

27 Polarizer

31 Light source

EP 0 341 003 B1

# Fig.11